# FASCICULE DE BREVET EUROPEEN

(11) **EP 2 054 338 B1**
(45) Date de publication et mention de la délivrance du brevet: **11.11.2009**
(21) Numéro de dépôt: 07727715.0
(22) Date de dépôt: 03.04.2007
(51) Int. Cl.: B81C 1/00

(54) **PROTECTION DE CAVITES DEBOUCHANT SUR UNE FACE D'UN ELEMENT MICROSTRUCTURE.**
SCHUTZ VON IN EINER FLÄCHE EINES MIKROSTRUKTURIERTEN ELEMENTS MÜNDENDEN HOHLRÄUMEN
PROTECTION OF CAVITIES OPENING ONTO A FACE OF A MICROSTRUCTURED ELEMENT

(30) Priorité: 05.04.2006 FR 0651210
(43) Date de publication de la demande: 06.05.2009
(73) Titulaire: COMMISSARIAT A L'ENERGIE ATOMIQUE, 75015 Paris (FR)
(72) Inventeur: CHARLET, Barbara, F-38330 Montbonnot Saint Martin (FR); LE POCHE, Hélène, F-38000 Grenoble (FR); GOBIL, Yveline, F-38000 Grenoble (FR)
(74) Mandataire: Ilgart, Jean-Christophe
(86) Numéro de dépôt international: PCT/EP2007/053244
(87) Numéro de publication internationale: WO 2007/113300

(56) Documents cités:
- EP-A2- 0 483 814
- EP-A2- 1 529 753
- WO-A-99/23682
- US-A- 5 882 532
- US-B1- 6 528 930

## Description

### DOMAINE TECHNIQUE

L'invention se rapporte à la fabrication de dispositifs comportant des microstructures. Elle concerne en particulier le domaine des microtechnologies pour des applications en microélectronique ou en microfluidique.

### ÉTAT DE LA TECHNIQUE ANTÉRIEURE

Dans le domaine des microtechnologies, on trouve fréquemment des éléments de taille micrométrique ou même nanométrique disposés dans des cavités débouchant sur une face d'un substrat. Ces éléments peuvent par exemple être des micropointes disposées dans des puits ou dans des gorges d'une structure de cathode à émission de champ. Une fois les micropointes formées dans les cavités, il se pose le problème des traitements ultérieurs, par exemple pour réaliser la connectique nécessaire à l'adressage individuel, ou par groupes, de ces micropointes. En effet, les micropointes constituent des éléments vulnérables à certaines étapes technologiques. Il n'existe actuellement pas de solution particulièrement appropriée pour la protection de ces éléments vulnérables.

Le document FR-A-2 715 502 (correspondant au brevet américain No. 5 804 086) divulgue un procédé de réalisation d'une structure comportant un substrat apte à supporter une tranche superficielle en un matériau non conducteur pour la réalisation de circuits intégrés, des cavités internes étant disposées sous la tranche superficielle, dans le substrat. Les cavités internes ainsi réalisées sont utilisées pour former des canaux de circulation d'un fluide de refroidissement des circuits intégrés réalisés dans la tranche superficielle. Ainsi, les cavités formées superficiellement dans le substrat sont bouchées par report d'une couche mince. Cependant, les cavités fermées par le procédé divulgué par ce document n'ont pas une atmosphère contrôlée. Par ailleurs, la fragilité de la structure obtenue ne permet pas de réaliser des étapes de certains procédés microélectroniques et notamment des traitements thermiques et/ou chimiques pour la réalisation de structures complexes.

D'autre part, on connaît, par le document FR-A-2 803 438 (correspondant au brevet américain No. 6 875 686), un procédé de réalisation d'une structure d'interconnexions comprenant une isolation électrique incluant des cavités d'air ou de vide. Ces cavités sont réalisées dans une première couche d'un matériau déposée sur un substrat. Une deuxième couche d'un autre matériau est déposée sur la première couche, le dépôt de cette deuxième couche ne comblant pas les cavités réalisées dans la première couche. Il s'agit donc d'un dépôt de type non conforme. Dans le cas de ce document, il s'agit de réaliser des tranchées d'isolation électrique.

Le brevet américain US6528930 se rapporte à un afficheur à émission par effet de champ. Ce document divulgue un procédé de fabrication qui comprend le dépôt d'une couche non-conforme afin de sceller des cavités qui débouchent sur une face un substrat.

### EXPOSÉ DE L'INVENTION

Le but de la présente invention est la protection efficace de cavités débouchant sur une face d'un élément microstructuré. Cette protection efficace des cavités permet la réalisation d'une ou de plusieurs étapes technologiques pouvant, en l'absence de protection, porter préjudice aux cavités, soit aux cavités elles-mêmes, soit à un dispositif ou élément contenu dans les cavités.

L'invention a pour objet un procédé de fabrication d'un dispositif comportant au moins un élément microstructuré constitué par un premier substrat présentant une première face et une deuxième face opposée à la première face, au moins une cavité présentant une partie d'intérêt débouchant sur la première face, comprenant :
- le dépôt sur ladite première face du premier substrat d'une couche non conforme de matériau de protection, ladite couche non conforme bouchant la cavité sans recouvrir la partie d'intérêt ;
**caractérisé en ce que** le procédé comprend en outre :
- la mise en oeuvre d'un procédé technologique appliqué au premier substrat en vue de fabriquer ledit dispositif, le procédé technologique comprenant la fixation sur la face libre de la couche non conforme d'un deuxième substrat et incluant au moins une étape délicate pour la partie d'intérêt ;
- l'élimination, au moins partielle, de la couche non conforme pour révéler la partie d'intérêt.

Par élément microstructuré, on entend tout élément présentant des parties de taille micrométrique ou nanométrique, faisant par exemple partie des domaines de la microélectronique ou de la microfluidique.

Par partie d'intérêt, on entend tout élément inclus dans une cavité et vulnérable à au moins une étape technologique, dite étape délicate. Cet élément inclus peut être un élément actif, par exemple un nanodispositif tel qu'un élément émetteur d'électrons à effet de champ (nanotubes, nanofils, micropointes, germe de croissance, dépôt de catalyseur). Il peut s'agir d'au moins une paroi de la cavité ou de la cavité elle-même (couche vulnérable comme certains polymères ou des métaux facilement oxydables en atmosphère non contrôlée).

Par couche non conforme, on entend une couche d'un matériau qui, lorsqu'il est déposé sur une surface non uniforme, n'épouse pas systématiquement tout le relief de cette surface, mais laisse des parties de cette surface (parties constituées de cavités de faibles dimensions) non recouvertes par ladite couche.

Le deuxième substrat peut posséder une partie active (des circuits ou des dispositifs). Dans ce cas, il peut constituer avec le premier substrat un ensemble cohérent d'une structure (intégration 3D). Il peut aussi avoir la fonction d'une poignée permettant la poursuite d'opérations d'intégration sur les faces externes de l'ensemble obtenu. A titre d'exemple d'opérations d'intégration, on peut citer l'amincissement du premier substrat et/ou de la poignée, la formation de couches sur les faces externes, la modification des propriétés des faces externes, sans interaction avec les faces internes de l'ensemble.

La couche de matériau de protection fermant la cavité ou les cavités assure une fonction de scellement mécanique et chimique. Elle assure la protection de la partie d'intérêt de chaque cavité. Cette fermeture empêche l'interaction de l'intérieur d'une cavité avec une atmosphère ambiante et/ou agressive au cours de différentes étapes d'intégration.

Avantageusement, la fixation du deuxième substrat sur la couche non conforme est réalisée par collage moléculaire ou par une substance adhésive.

Le premier substrat peut être aminci à partir de sa deuxième face.

Le procédé de fabrication peut comprendre en outre au moins une étape de traitement du premier substrat pour y réaliser des moyens constitutifs du dispositif. Ces moyens constitutifs du dispositif peuvent être choisis parmi des éléments de connexion électrique, des éléments de connexion fluidique, des éléments de connexion optique, des composants électroniques, des composants fluidiques, des composants optiques et des composants optoélectriques. Ils peuvent comprendre des moyens d'accès électrique ou fluidique à la partie d'intérêt de la cavité.

Le procédé de fabrication peut comprendre en outre une étape de fixation d'un troisième substrat sur la face libre du premier substrat. Cette fixation peut être réalisée par collage moléculaire ou par une substance adhésive. Le troisième substrat peut comporter des moyens constitutifs du dispositif. Ces moyens constitutifs peuvent être choisis parmi des éléments de connexion électrique, des éléments de connexion optique, des éléments de connexion fluidique, des composants électroniques, des composants fluidiques, des composants optiques et des composants optoélectroniques. Ils peuvent comprendre des moyens d'accès électrique, fluidique ou optique à la partie d'intérêt de la cavité.

Une étape supplémentaire peut être prévue pour éliminer le deuxième substrat. Il peut être prévu en outre une étape d'élimination au moins partielle de la couche non conforme de matériau de protection.

Un autre objet de l'invention consiste en un procédé de réalisation d'une structure de cathode à émission de champ mettant en oeuvre le procédé de fabrication ci-dessus, la partie d'intérêt d'une cavité étant constituée par des moyens émetteurs d'électrons. Les moyens émetteurs d'électrons peuvent comprendre au moins une micropointe.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 représente, vu en coupe transversale, un substrat dont une surface est pourvue de cavités contenant des micropointes,
- la figure 2 représente, vu en coupe transversale, le substrat de la figure 1 dont la surface est revêtue d'une couche non conforme,
- la figure 3 représente, vu en coupe transversale, le substrat de la figure 2 dont une face a été amincie et donc l'autre face est rendue solidaire d'une poignée,
- la figure 4 représente, vue en coupe transversale, la solidarisation du substrat de la figure 3 avec un circuit microélectronique,
- la figure 5, représente, vu en coupe transversale, le substrat de la figure 4 auquel la poignée a été retirée,
- la figure 6, représente, vu en coupe transversale, le substrat de la figure 5 où les cavités ont été réouvertes et où une interconnexion a été réalisée.

### EXPOSÉ DÉTAILLÉ D'UN MODE DE RÉALISATION PARTICULIER

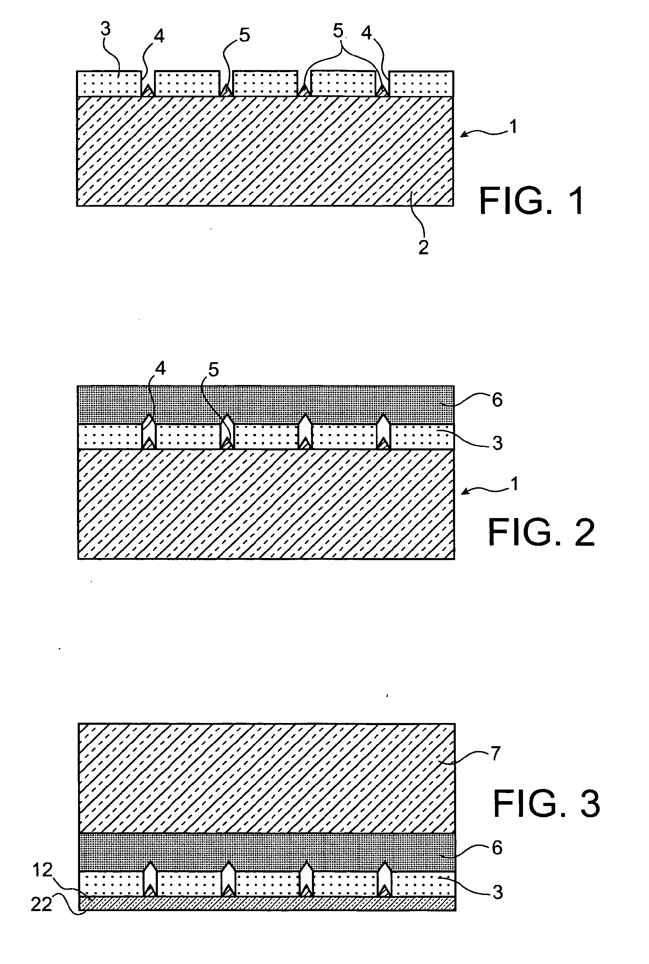

La figure 1 représente, vu en coupe transversale, un substrat dont une surface est pourvue de cavités contenant des micropointes.

Le substrat 1 est constitué d'une plaquette 2, par exemple en silicium ou en silicium-sur-isolant (SOI), supportant une couche mince 3, par exemple en oxyde de silicium. Des cavités 4 ont été formées dans la couche mince 3, par une technique de gravure bien connue de l'homme de l'art. Au fond des cavités 4, on a formé des microstructures, par exemple des microcapteurs ou, comme représenté sur la figure 1, des micropointes 5 par une technique de formation bien connue de l'homme de l'homme de l'art. Chaque cavité peut comporter une ou plusieurs microstructures.

La figure 2 représente le substrat 1 de la figure 1 comportant, sur la couche mince 3, une couche non conforme 6. A titre d'exemple, la couche non conforme 6 peut être une couche de SiO₂ déposée par un procédé PVD ou PECVD dans un bâti adapté aux conditions de dépôt non conforme (en termes de gaz, pressions, polarisation du substrat, température, etc.). A titre d'exemple, on peut obtenir un dépôt non conforme de SiO₂ par un procédé PECVD dans le bâti Applied P5000 dans les conditions suivantes : température 400°C, puissance 200 W, débit de SiH₄ 50 cm³/min et débit de N₂O 1800 cm³/min. En variante, la couche non conforme peut être métallique (par exemple en aluminium, en platine, en tungstène) et peut être déposée par un procédé PVD. A titre d'exemple, on peut obtenir un dépôt non conforme d'aluminium par dépôt PVD dans un bâti Applied Endura dans les conditions suivantes : température 450°C, puissance 1,2 kW et débit d'argon pour pulvériser une cible en AlCu. Dans cet exemple de réalisation, la couche non conforme 6 bouche les cavités 4 en préservant les micropointes 5. La fermeture des cavités par la couche non conforme permet, en bouchant les cavités sous atmosphère contrôlée, la réalisation d'étapes de microélectronique pouvant nécessiter des traitements thermiques et/ou chimiques sans détérioration des micropointes. Par ailleurs, l'utilisation de ce dépôt non conforme permet d'obtenir une structure avantageusement planaire ou apte à être planarisée par des techniques standard, ce qui permet la réalisation d'étapes ultérieures, en particulier de lithographie, de traitement chimique, de collage moléculaire, etc.

Un substrat poignée 7, par exemple en silicium est ensuite fixé sur la face libre de la couche non conforme 6, par exemple par collage moléculaire ou par une substance adhésive. C'est ce que montre la figure 3. Dans le cas d'un collage moléculaire, notamment lorsque les ouvertures des cavités sont supérieures à 1 µm, il est avantageux d'utiliser préalablement une étape de planarisation de surface de la couche non conforme. Un dépôt non conforme en couche mince (effectué par exemple par PECVD, PVD...) n'est pas doté naturellement d'une surface lisse, en particulier après un recouvrement de cavités. De ce fait, la surface libre d'une couche de matériau non conforme n'est pas apte à être fixée sur une autre surface par collage moléculaire. En effet, pour ce type de collage, la rugosité de surface doit être très inférieure à 1 nm RMS. Les valeurs typiques de rugosité de surface pour un dépôt non conforme réalisé sur une surface sans topologie se situent dans une gamme de quelques centaines de nm RMS pour les couches non conformes d'épaisseur supérieure à 1 µm et dans une gamme de quelques dizaines de nm RMS pour les couches non conformes plus minces. Ces valeurs peuvent varier en fonction de la nature du dépôt et selon la topologie de la surface sur laquelle il est déposé. Pour effectuer un collage direct d'une couche non conforme, il est donc indispensable de lisser cette couche pour la rendre apte à être collée avec une surface qui possède les caractéristiques requises pour un collage moléculaire efficace.

Les cavités micrométriques et nanométriques peuvent être recouvertes par le dépôt d'une couche non conforme. Par exemple, pour un dépôt PECVD non conforme, les diamètres d'ouverture maximale de cavités recouvrables sont d'environ 2 µm. Dans le cas d'un recouvrement total (fermeture de cavité par un dépôt PECVD), l'épaisseur totale de la couche déposée est supérieure à la moitié de la plus grande dimension de l'ouverture surcafique de cette cavité. L'épaisseur du dépôt est indépendante du facteur de forme des cavités à recouvrir. La présence des cavités contribue à l'augmentation de la rugosité de la surface de la couche non conforme. Il est alors difficile d'obtenir les conditions de rugosité de surface requises pour un collage moléculaire sans une préparation appropriée.

Une surface lisse ou de faible rugosité peut être obtenue par un procédé de polissage mécano-chimique, par finition de surface mécanique, thermique, thermo-optique (laser), thermoïonique (plasma) ou chimique. Une surface ainsi planarisée peut ensuite être conditionnée pour un collage direct (appelé aussi collage moléculaire) par des procédés assurant les affinités requises entre les surfaces à mettre en contact, par exemple des liaisons entre deux surfaces hydrophiles établies par les forces intermoléculaires. Les traitements de planarisation et de conditionnement avant le collage de telles surfaces peuvent être effectués par des procédés standard, sans perturbation des dispositifs ou parties d'intérêt enfermés dans les cavités.

Le substrat 1 est alors aminci de sorte qu'il ne subsiste plus de la plaquette 2 qu'une partie amincie 12 présentant une face libre 22. L'amincissement peut être réalisé par un procédé de polissage mécano-chimique ou par le procédé Smartcut^{®} divulgué par le document FR-A-2 681 472 (correspondant au brevet américain US 5 374 564). La partie amincie 12 peut être utilisée pour former des éléments de connectiques, des transistors, des éléments optiques, etc.

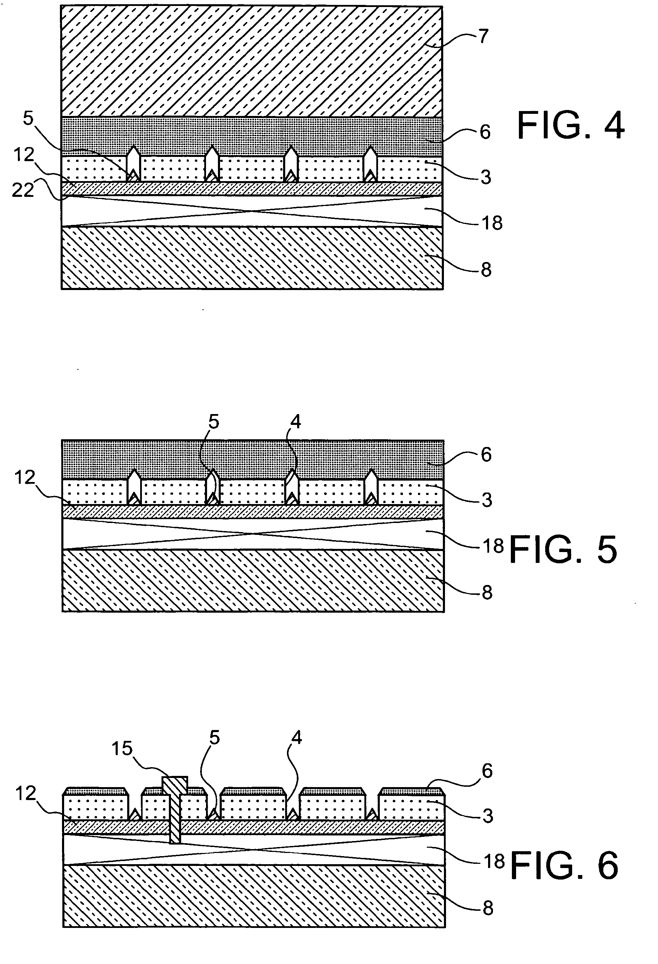

La partie amincie 12 peut également recevoir un substrat 8 fixé sur la face 22 par exemple par collage moléculaire ou par une substance adhésive. C'est ce que montre la figure 4. Ce substrat 8 peut avantageusement comporter un circuit électronique 18 (par exemple un circuit MOS) destiné à fonctionner en relation avec les micropointes 5.

Le substrat poignée peut alors être aminci ou éliminé, par exemple par polissage mécano-chimique ou par décollement. On obtient la structure montrée à la figure 5. A ce stade d'intégration, une réalisation des étapes technologiques entre le circuit MOS et des dispositifs enfermés dans les cavités est possible puisque les cavités restent protégées par le dépôt non conforme qui les scelle. Une élimination partielle ou totale de la couche non conforme 6 est possible à l'étape appropriée pour la structure finale.

On peut ensuite, comme illustré sur la figure 6, procéder à une étape facultative d'amincissement mécanique de la couche non conforme 6 puis pratiquer localement des ouvertures dans la couche 6 pour réaliser des interconnexions 15 entre par exemple la face libre de la couche mince 3 et le circuit électronique 18. Les cavités peuvent alors être réouvertes, par exemple par gravure chimique de la couche non conforme 6.

A titre d'exemple, la description a porté sur un substrat dont une surface est pourvue de cavités contenant des micropointes. L'invention s'applique bien sûr à d'autres parties d'intérêt, par exemple des nanotubes (les nanotubes de carbone entre autres), notamment pour l'application cathode à émission de champ.

## Revendications

1. Procédé de fabrication d'un dispositif comportant au moins un élément microstructuré (1) constitué par un premier substrat présentant une première face et une deuxième face opposée à la première face, au moins une cavité (4) présentant une partie d'intérêt (5) débouchant sur la première face, comprenant :
- le dépôt sur ladite première face du premier substrat d'une couche non conforme (6) de matériau de protection, ladite couche non conforme bouchant la cavité sans recouvrir la partie d'intérêt ;
**caractérisé en ce que** le procédé comprend en outre :
- la mise en oeuvre d'un procédé technologique appliqué au premier substrat en vue de fabriquer ledit dispositif, le procédé technologique comprenant la fixation sur la face libre de la couche non conforme (6) d'un deuxième substrat (7) et incluant au moins une étape délicate pour la partie d'intérêt ;
- l'élimination, au moins partielle, de la couche non conforme (6) pour révéler la partie d'intérêt.

2. Procédé de fabrication selon la revendication 1, **caractérisé en ce que** la fixation du deuxième substrat (7) sur la couche non conforme (6) est réalisée par collage moléculaire ou par une substance adhésive.

3. Procédé de fabrication selon l'une des revendications 1 ou 2, **caractérisé en ce que** le premier substrat (1) est aminci à partir de sa deuxième face.

4. Procédé de fabrication selon l'une quelconque des revendications 1 à 3, **caractérisé en ce qu'**il comprend en outre au moins une étape de traitement du premier substrat (1) pour y réaliser des moyens constitutifs du dispositif.

5. Procédé de fabrication selon la revendication 4, **caractérisé en ce que** les moyens constitutifs du dispositif sont choisis parmi des éléments de connexion électrique, des éléments de connexion fluidique, des éléments de connexion optique, des composants électroniques, des composants fluidiques, des composants optiques et des composants optoélectriques.

6. Procédé de fabrication selon l'une des revendications 4 ou 5, **caractérisé en ce que** lesdits moyens constitutifs du dispositif comprennent des moyens d'accès électrique ou fluidique à la partie d'intérêt de la cavité.

7. Procédé de fabrication selon l'une quelconque des revendications 1 à 3, **caractérisé en ce qu'**il comprend en outre une étape de fixation d'un troisième substrat (8) sur la face libre du premier substrat.

8. Procédé de fabrication selon la revendication 7, **caractérisé en ce que** la fixation du troisième substrat (8) sur le premier substrat est réalisée par collage moléculaire ou par une substance adhésive.

9. Procédé de fabrication selon l'une des revendications 7 ou 8, **caractérisé en ce que** le troisième substrat (8) comporte des moyens constitutifs du dispositif.

10. Procédé de fabrication selon la revendication 9, **caractérisé en ce que** lesdits moyens constitutifs du dispositif sont choisis parmi des éléments de connexion électrique, des éléments de connexion optique, des éléments de connexion fluidique, des composants électroniques, des composants fluidiques, des composants optiques et des composants optoélectroniques.

11. Procédé de fabrication selon l'une des revendications 9 ou 10, **caractérisé en ce que** lesdits moyens constitutifs du dispositif comprennent des moyens d'accès électrique, fluidique ou optique à la partie d'intérêt de la cavité.

12. Procédé de fabrication selon l'une quelconque des revendications 3 à 11, **caractérisé en ce qu'**il comprend en outre une étape d'élimination totale ou partielle du deuxième substrat (7).

13. Procédé de fabrication selon la revendication 12, **caractérisé en ce qu'**il comprend en outre une étape d'élimination au moins partielle de la couche non conforme (6) de matériau de protection.

14. Procédé de réalisation d'une structure de cathode à émission de champ mettant en oeuvre le procédé selon l'une quelconque des revendications 1 à 13, la partie d'intérêt d'une cavité étant constituée par des moyens émetteurs d'électrons.

15. Procédé selon la revendication 14,
**caractérisé en ce que** les moyens émetteurs d'électrons comprennent au moins une micropointe (5).

## Claims

1. Method for producing a device comprising at least one microstructured element (1) consisting of a first substrate having a first face and a second face opposite the first face, in which at least one cavity (4) has a portion of interest (5) opening onto the first face, including:
- the deposition on said first face of the first substrate of a nonconformal layer (6) of protective material, in which said nonconformal layer closes off the cavity without covering the portion of interest;
**characterised in that** the method also includes:
- the implementation of a technological method applied to the first substrate in order to produce said device, in which the technological method includes the attachment on the free face of the nonconformal layer (6) of a second substrate (7) and includes at least one delicate step for the portion of interest;
- the at least partial removal of the nonconformal layer (6) to expose the portion of interest.

2. Production method according to claim 1, **characterised in that** the attachment of the second substrate (7) on the nonconformal layer (6) is carried out by molecular bonding or using an adhesive substance.

3. Production method according to one of claims 1 or 2, **characterised in that** the first substrate (1) is thinned from its second face.

4. Production method according to any one of claims 1 to 3, **characterised in that** it also includes at least one step of treating the first substrate (1) in order to produce the means constituting the device.

5. Production method according to claim 4,
**characterised in that** the means constituting the device are chosen from among electrical connection elements, fluidic connection elements, optical connection elements, electronic components, fluidic components, optical components and optoelectric components.

6. Production method according to one of claims 4 or 5, **characterised in that** said means constituting the device include means for electrical or fluidic access to the portion of interest of the cavity.

7. Production method according to any one of claims 1 to 3, **characterised in that** it also includes a step of attaching a third substrate (8) to the free face of the first substrate.

8. Production method according to claim 7,
**characterised in that** the attachment of the third substrate (8) to the first substrate is carried out by molecular bonding or using an adhesive substance.

9. Production method according to one of claims 7 or 8, **characterised in that** the third substrate (8) comprises means constituting the device.

10. Production method according to claim 9, **characterised in that** said means constituting the device are chosen from among electrical connection elements, optical connection elements, fluidic connection elements, electronic components, fluidic components, optical components and optoelectric components.

11. Production method according to one of claims 9 or 10, **characterised in that** said means constituting the device include means for electrical, fluidic or optical access to the portion of interest of the cavity.

12. Production method according to any one of claims 3 to 11, **characterised in that** it also includes a step of total or partial removal of the second substrate (7).

13. Production method according to claim 12, **characterised in that** it also includes a step of at least partial removal of the nonconformal layer (6) of protective material.

14. Method for producing a field-emission cathode structure implementing the method according to any one of claims 1 to 13, **characterised in that** the portion of interest of a cavity consists of electron emitting means.

15. Method according to claim 14, **characterised in that** the electron emitting means include at least one microtip (5).

## Patentansprüche

1. Verfahren zur Herstellung einer Vorrichtung mit wenigstens einem mikrostrukturierten Element (1), gebildet durch ein erstes Substrat mit einer ersten Fläche und einer der ersten Fläche entgegengesetzten zweiten Fläche, wenigstens einer in der ersten Fläche mündenden Kavität (4) mit einem interessierenden Teil (5), umfassend:
- das Abscheiden auf der genannten ersten Fläche des ersten Substrats einer nichtkonformen Schicht (6) aus Schutzmaterial, wobei die genannte nichtkonforme Schicht den Hohlraum verschließt, ohne den interessierenden Teil zu bedecken;
**dadurch gekennzeichnet, dass** das Verfahren außerdem umfasst:
- das Anwenden eines technologischen Verfahrens hinsichtlich der Herstellung der genannten Vorrichtung auf das erste Substrat, wobei das technologische Verfahren die Fixierung eines zweiten Substrats (7) auf der nichtkonformen Schicht (6) umfasst und wenigstens einen für den interessierenden Teil delikaten Schritt einschließt;
- das wenigstens partielle Eliminieren der nichtkonformen Schicht (6), um den interessierenden Teil zu enthüllen.

2. Herstellungsverfahren nach Anspruch 1, **dadurch gekennzeichnet, dass** die Fixierung des zweiten Substrats (7) auf der nichtkonformen Schicht (6) durch molekulare Haftung oder durch eine Haftsubstanz realisiert wird.

3. Herstellungsverfahren nach einem der Ansprüche 1 oder 2, **dadurch gekennzeichnet, dass** das erste Substrat (1) einer von seiner zweiten Fläche bzw. Seite ausgehenden Dünnung unterzogen wird.

4. Herstellungsverfahren nach einem der Ansprüche 1 bis 3, **dadurch gekennzeichnet, dass** es außerdem wenigstens einen Schritt zur Behandlung des ersten Substrats (1) umfasst, um dort konstitutive Einrichtungen der Vorrichtung zu realisieren.

5. Herstellungsverfahren nach Anspruch 4, **dadurch gekennzeichnet, dass** die konstitutiven Einrichtungen der Vorrichtung ausgewählt werden unter elektrischen Verbindungselementen, fluidischen Verbindungselementen, optischen Verbindungselementen, elektronischen Komponenten, fluidischen Komponenten, optischen Komponenten und optoelektrischen Komponenten.

6. Herstellungsverfahren nach einem der Ansprüche 4 oder 5, **dadurch gekennzeichnet, dass** die genannten konstitutiven Einrichtungen der Vorrichtung Einrichtungen für den elektrischen oder fluidischen Zugriff auf den interessierenden Teil des Hohlraums umfassen.

7. Herstellungsverfahren nach einem der Ansprüche 1 bis 3, **dadurch gekennzeichnet, dass** es außerdem einen Schritt zur Fixierung eines dritten Substrats (8) auf der freien Fläche des ersten Substrats umfasst.

8. Herstellungsverfahren nach Anspruch 7, **dadurch gekennzeichnet, dass** die Fixierung des dritten Substrats (8) auf dem ersten Substrat durch molekulare Haftung oder durch eine Haftsubstanz erfolgt.

9. Herstellungsverfahren nach einem der Ansprüche 7 oder 8, **dadurch gekennzeichnet, dass** das dritte Substrat (8) konstitutive Einrichtungen der Vorrichtung umfasst.

10. Herstellungsverfahren nach Anspruch 9, **dadurch gekennzeichnet, dass** die genannten konstitutiven Einrichtungen der Vorrichtung ausgewählt werden unter elektrischen Verbindungselementen, optischen Verbindungselementen, fluidischen Verbindungselementen, elektronischen Komponenten, fluidischen Komponenten, optischen Komponenten und optoelektrischen Komponenten.

11. Herstellungsverfahren nach einem der Ansprüche 9 oder 10, **dadurch gekennzeichnet, dass** die genannten konstitutiven Einrichtungen der Vorrichtung Einrichtungen für den elektrischen oder fluidischen oder optischen Zugriff auf den interessierenden Teil des Hohlraums umfassen.

12. Herstellungsverfahren nach einem der Ansprüche 3 bis 11, **dadurch gekennzeichnet, dass** es außerdem einen Schritt zur totalen oder partiellen Eliminierung des zweiten Substrats (7) umfasst.

13. Herstellungsverfahren nach Anspruch 12, **dadurch gekennzeichnet, dass** es außerdem einen Schritt zur totalen oder partiellen Eliminierung der nichtkonformen Schicht (6) aus Schutzmaterial umfasst.

14. Verfahren zur Realisierung einer Feldemissionskathodenstruktur, wobei das Verfahren nach einem der Ansprüche 1 bis 13 angewendet wird, und der interessierende Teil eines Hohlraums durch Elektronenemissionseinrichtungen gebildet wird.

15. Verfahren nach Anspruch 14, **dadurch gekennzeichnet, dass** die Elektronenemissionseinrichtungen wenigstens eine Mikrospitze (5) umfassen.
